# EUROPEAN PATENT APPLICATION

(11) **EP 4 811 971 A1**
(43) Date of publication of application: **23.09.2026**
(21) Application number: 24891676.9
(22) Date of filing: 28.10.2024
(51) Int. Cl.: H10F 39/12

(54) **IMAGE SENSOR PACKAGE**

(30) Priority: 14.11.2023 KR 20230157594
(71) Applicant: LG Innotek Co., Ltd., Seoul 07796 (KR)
(72) Inventor: JANG, Sung Woo, Seoul 07796 (KR)
(74) Representative: Plasseraud IP
(86) International application number: PCT/KR2024/016542
(87) International publication number: WO 2025/105729

(57) **Abstract**

An image sensor package, according to one embodiment of the present invention, comprises: an image sensor; a first film disposed on a first region which is the center region of one surface of the image sensor; and solder balls disposed on a second region which is more to the outside than the first region on the one surface of the image sensor, wherein the solder balls and the first film are arranged so as to be spaced apart in the direction perpendicular to an optical axis.

## Description

### [Technical Field]

The present invention relates to an image sensor package.

### [Background Art]

Generally, camera devices are being mounted on electronic devices such as automobiles, endoscopes, and CCTVs, as well as portable devices such as mobile communication terminals and MP3 players. Such camera devices are gradually developing toward high pixels, and miniaturization and thinning are progressing. In addition, current camera devices are changing so that various additional functions can be implemented at a low manufacturing cost.

The camera device as described above comprises: a lens barrel accommodating a lens; a lens holder coupled to the lens barrel; an image sensor disposed within the lens holder; and a driving substrate on which the image sensor is mounted. At this time, the lens transmits an image signal of a subject to the image sensor. Then, the image sensor converts the image signal into an electrical signal. As the image sensor becomes larger, it can receive more light, so that a high-definition image can be obtained even in a low-light environment.

### [Detailed Description of the Invention]

### [Technical Subject]

The technical problem to be solved by the present invention is to provide an image sensor package.

### [Technical Solution]

In order to solve the technical problem described above, an image sensor package according to one embodiment of the present invention comprises: an image sensor; a first film disposed on a first region which is the center region of one surface of the image sensor; and solder balls disposed on a second region which is more to the outside than the first region on the one surface of the image sensor, wherein the solder balls and the first film are arranged so as to be spaced apart in the direction perpendicular to an optical axis.

The image sensor package is disposed on a substrate, and the solder balls may be soldered on the substrate.

A ratio of a thickness of the image sensor in the optical axis direction to a thickness of the first film in the optical axis direction may be 1:3 to 1:5.

The first film may be made of a non-conductive material.

The image sensor package may comprise a second film disposed on a third region which is more to the outside than the second region on the one surface of the image sensor.

The second film and the solder balls may be arranged so as to be spaced apart in the direction perpendicular to the optical axis.

The second film may be made of a non-conductive material.

In order to solve the technical problem described above, an image sensor package according to another embodiment of the present invention may comprise: an image sensor; a first film disposed on a first region which is the center of one surface of the image sensor; and a third film disposed on a second region which is more to the outside than the first region on the one surface of the image sensor.

The first film and the third film may be formed as one film.

The first film may be made of a non-conductive material, and the third film may be made of a conductive material.

### [Advantageous Effects]

According to the embodiments, crack damage of the image sensor can be prevented.

In addition, since an underfill process can be omitted when attaching the image sensor to a substrate, an overflow problem can be prevented.

In addition, by reducing a thickness of the image sensor, mechanical and optical degrees of freedom of a camera module can be secured, and the camera module can be miniaturized.

### [Brief Description of Drawings]

FIG. 1 is a view for explaining a problem occurring in an image sensor package.
FIG. 2 is a view showing an image sensor package according to the present embodiment.
FIG. 3 is an enlarged view showing a region X of FIG. 2.
FIG. 4 (a) is a view for explaining a cutting process of a first film included in the image sensor package according to the present embodiment, and FIG. 4 (b) is a view showing the first film cut according to the cutting process shown in FIG. 4 (a).
FIG. 5 is a view showing the image sensor package according to the present embodiment.
FIG. 6 is a view showing an image sensor package according to another embodiment of the present invention.
FIG. 7 is a view showing an image sensor package according to still another embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms including technical and scientific terms) used in the embodiments unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

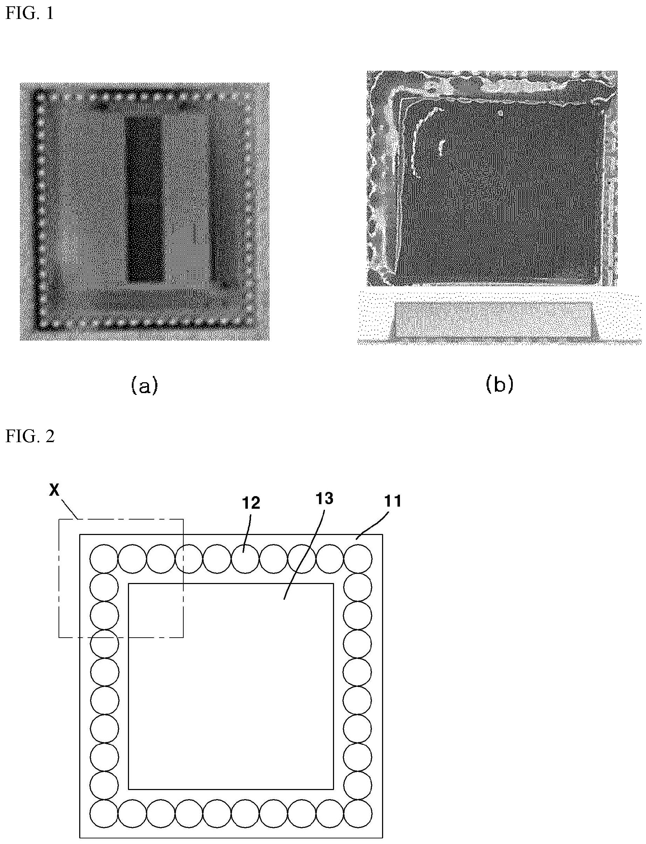

FIG. 1 is a view for explaining a problem occurring in an image sensor package. FIG. 1 (a) is a view showing a bottom surface of an image sensor, and FIG. 1 (b) is a view showing the image sensor in which crack damage has occurred and an overflow phenomenon occurring during an underfill process when the image sensor is disposed on a substrate.

A thickness of a thin film of an image sensor is becoming smaller due to an increase in QE (Quantum Efficiency) and a minimization of a pin map of the image sensor. Due to this, a hollow occurs in a center region of the image sensor. When the image sensor is disposed on the substrate, a BGA (Ball Grid Array) is disposed on an edge region of the bottom surface of the image sensor as shown in FIG. 1 (a).

Thereafter, there is a problem that an overflow phenomenon occurs when an epoxy underfill process is performed between the image sensor and the substrate. Alternatively, there is a problem that a crack occurs in the image sensor due to an underfill shortage between the image sensor and the substrate.

The present invention is to solve such a problem, and an image sensor package according to the present embodiment can prevent crack damage of an image sensor. In addition, since an underfill process can be omitted when attaching the image sensor to a substrate, an overflow problem can be prevented. In addition, by reducing a thickness of the image sensor, mechanical and optical degrees of freedom of a camera module can be secured, and the camera module can be miniaturized.

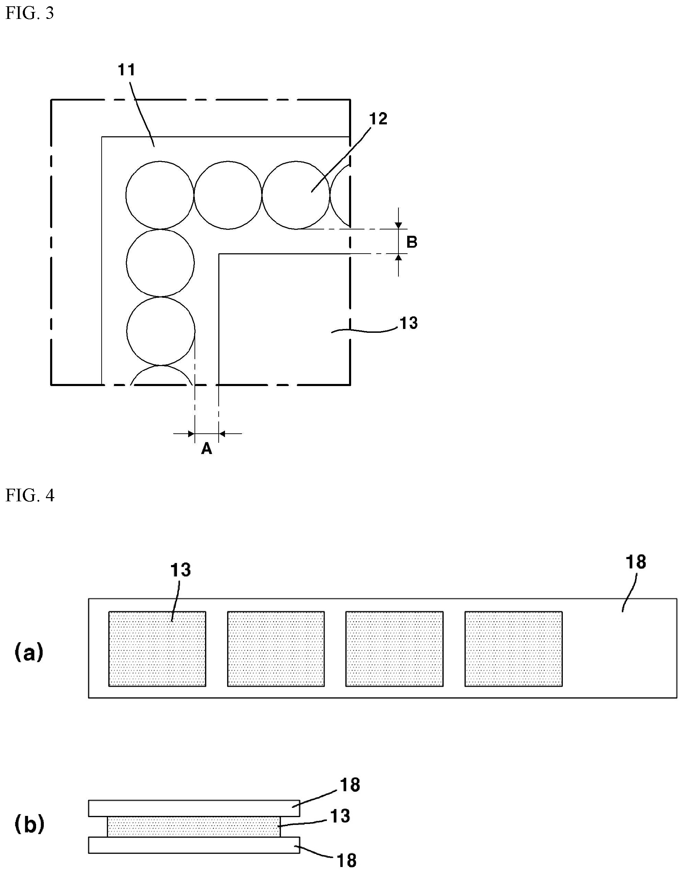

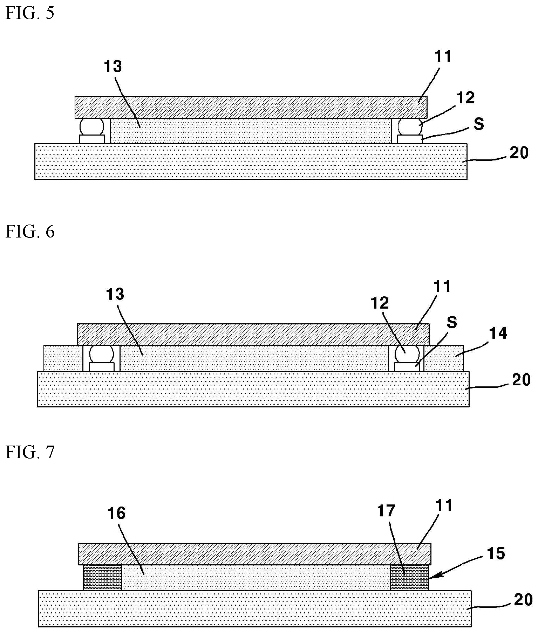

FIG. 2 is a view showing an image sensor package according to the present embodiment; FIG. 3 is an enlarged view showing a region X of FIG. 2; FIG. 4 (a) is a view for explaining a cutting process of a first film included in the image sensor package according to the present embodiment; FIG. 4 (b) is a view showing the first film cut according to the cutting process shown in FIG. 4 (a); FIG. 5 is a view showing the image sensor package according to the present embodiment; FIG. 6 is a view showing an image sensor package according to another embodiment of the present invention; and FIG. 7 is a view showing an image sensor package according to still another embodiment of the present invention.

The image sensor package according to the present embodiment may comprise an image sensor **11**, a first film **13**, and solder balls **12**, and may comprise a second film **14**. The image sensor package may be disposed on a substrate **20**. The image sensor package may be attached to the substrate **20**. The image sensor package may be mounted on the substrate **20**.

The image sensor **11** may include a first region which is a center region of one surface and a second region which is more to the outside than the first region. The second region may be referred to as an edge region. The image sensor **11** may include a third region which is more to the outside than the second region. The third region may be referred to as an outermost region. The second region, which is the edge region, may mean a region more to the inside than the third region, which is the outermost region. The one surface of the image sensor **11** may be a bottom surface attached to the substrate **20**.

A first film **13** may be disposed on a first region which is a center region of one surface of an image sensor **11**. The first film **13** may be a DAF (Die Attach Film). The DAF is a film used for adhesion between a die and a substrate when manufacturing a semiconductor image sensor package, and has a double-sided adhesion function. The first film **13** may be made of a non-conductive material.

Referring to FIG. 4 (a), the first film **13** is continuously disposed and manufactured on a protective tape **18** of a reel type. Thereafter, when the protective tape **18** is attached to the upper and lower surfaces of the first film **13**, it is cut for each single first film **13**. As shown in FIG. 4 (b), before being attached to the image sensor **11**, the first film **13** is in a state in which the protective tape **18** is attached to both sides thereof. When disposing on the image sensor **11**, the protective tape **18** is removed and the first film **13** is disposed on the first region of the image sensor **11**.

Solder balls **12** may be disposed on a second region of the one surface of the image sensor **11**. The solder balls **12** may be disposed in a BGA (Ball Grid Array) form in a region surrounding an edge of the first film **13**. A plurality of solder balls may be arranged so as to be spaced apart from each other; or a plurality of solder balls may be arranged so as to be in contact with each other. The solder balls **12** may be disposed on a substrate **20** and soldered **S**; or the solder balls **12** may be disposed on the substrate **20** and adhered with epoxy.

A first film **13** and solder balls **12** may be arranged so as to be spaced apart in a direction perpendicular to an optical axis. Since the solder balls **12**, which are made of a conductive material, must allow electrical signals to pass through, interference with the first film **13**, which is made of a non-conductive material, must be minimized. Accordingly, as shown in FIG. 3, surfaces of the solder balls **12** and the first film **13** facing each other may be arranged so as to be spaced apart. The solder balls **12** disposed on a left side of the first film **13** and the first film **13** may be spaced apart by **A**; and the solder balls **12** disposed on an upper side of the first film **13** and the first film **13** may be spaced apart by **B**. **A** and **B** may have different values; or **A** and **B** may have the same value. For example, **A** and **B** may be about 50 µm.

A thickness of an image sensor **11** in the optical axis direction may be about 0.05 mm. A thickness of the first film **13** in the optical axis direction may be about 0.2 mm. A thickness of the solder balls **12** in the optical axis direction may be about 0.19 mm. A ratio of the thickness of the image sensor **11** in the optical axis direction to the thickness of the solder balls **12** in the optical axis direction may satisfy 1:3 to 1:5, and preferably, may satisfy 1:3.5 to 1:4. A ratio of the thickness of the image sensor **11** in the optical axis direction to the thickness of the first film **13** in the optical axis direction may satisfy 1:3 to 1:5, and preferably, may satisfy 1:3.5 to 1:4. When these are satisfied, DAF bonding including a BGA can be performed, and product defects can be reduced by reducing the thickness in the optical axis direction and increasing flatness.

Referring to FIG. 6, a second film **14** may be disposed on a third region of the one surface of the image sensor **11**. The second film **14** may be disposed in an outside direction of the solder balls **12**. The second film **14** and the solder balls **12** may be arranged so as to be spaced apart in the direction perpendicular to the optical axis. The second film **14** may be disposed on a corner region of the image sensor **11**. When the solder balls **12** are arranged in a rectangular line, the second film **14** may be disposed in a region surrounding the solder balls **12**. The second film **14** may include a region overlapping the image sensor **11** in the optical axis direction; and a region not overlapping the image sensor **11** in the optical axis direction. Through this, crack damage of an edge region of the image sensor can be prevented.

An image sensor package according to still another embodiment of the present invention shown in FIG. 7 may comprise an image sensor **11**, a first film **16**, and a third film **17**.

The first film **16** is disposed on a first region which is a center region of one surface of the image sensor **11**; and the third film **17** may be disposed on a second region which is more to the outside than the first region on the one surface of the image sensor **11**. The first film **16** and the third film **17** may be formed as one film **15**. The first film **16** and the third film **17** may be each as separate films individually attached to the image sensor **11** or the substrate **20**. The first film **16** may be made of a non-conductive material; and the third film **17** may be made of a conductive material. The third film **17** may be a configuration disposed instead of the solder balls **12** described above.

The image sensor package according to still another embodiment of the present invention shown in FIG. 7 can manufacture an image sensor package through the attachment of one film, thereby simplifying a manufacturing process and increasing flatness of the image sensor attached on the substrate.

Those skilled in the art relating to the present embodiment will be able to understand that it can be implemented in a modified form within a range not departing from essential characteristics of the above description. Therefore, disclosed methods should be considered from an explanatory point of view rather than a limiting point of view. The scope of the present invention is shown in the claims rather than the foregoing description, and all differences within the equivalent scope should be interpreted as being included in the present invention.

## Claims

1. An image sensor package comprising:
an image sensor;
a first film disposed on a first region which is a center region of one surface of the image sensor; and
solder balls disposed on a second region which is more to the outside than the first region on the one surface of the image sensor,
wherein the solder balls and the first film are arranged so as to be spaced apart in a direction perpendicular to an optical axis.

2. The image sensor package according to claim 1,
wherein the image sensor package is disposed on a substrate, and wherein the solder balls are soldered onto the substrate.

3. The image sensor package according to claim 1,
wherein a ratio of a thickness of the image sensor in the optical axis direction to a thickness of the first film in the optical axis direction is 1:3 to 1:5.

4. The image sensor package according to claim 1,
wherein the first film is made of a non-conductive material.

5. The image sensor package according to claim 1, comprising:
a second film disposed on a third region which is more to the outside than the second region on the one surface of the image sensor.

6. The image sensor package according to claim 5,
wherein the second film and the solder balls are arranged so as to be spaced apart in a direction perpendicular to the optical axis.

7. The image sensor package according to claim 5,
wherein the second film is made of a non-conductive material.

8. An image sensor package, comprising:
an image sensor;
a first film disposed on a first region which is a center of one surface of the image sensor; and
a third film disposed on a second region which is more to the outside than the first region on the one surface of the image sensor.

9. The image sensor package according to claim 8,
wherein the first film and the third film are formed as one film.

10. The image sensor package according to claim 8,
wherein the first film is made of a non-conductive material, and
wherein the third film is made of a conductive material.
